# EUROPEAN PATENT SPECIFICATION

(11) **EP 2 550 665 B1**
(45) Date of publication and mention of the grant of the patent: **25.07.2018**
(21) Application number: 11716315.4
(22) Date of filing: 22.03.2011
(51) Int. Cl.: G03F 7/20, B82Y 10/00, G02B 5/08, G21K 1/06

(54) **MIRROR AND EXTREME ULTRAVIOLET LIGHT GENERATION SYSTEM**
SPIEGEL UND SYSTEM ZUM ERZEUGEN VON EXTREM UV STRAHLUNG
MIROIR ET SYSTÈME POUR LA PRODUCTION DE RADIATION UV EXTRÊME

(30) Priority: 20.12.2010 JP 2010283717; 25.03.2010 JP 2010070988
(43) Date of publication of application: 30.01.2013
(73) Proprietor: Gigaphoton Inc., Chiyoda-ku, Tokyo 100-0004 (JP)
(72) Inventor: KAMEDA, Hidenobu, Oyama-shi, Tochigi 323-0819 (JP); WAKABAYASHI, Osamu, Hiratsuka-shi, Kanagawa 254-8555 (JP); MORIYA, Masato, Oyama-shi, Tochigi 323-0819 (JP)
(74) Representative: Global IP Europe Patentanwaltskanzlei
(86) International application number: PCT/JP2011/057516
(87) International publication number: WO 2011/118830

(56) References cited:
- WO-A1-2010/020337
- WO-A2-2005/024848
- JP-A- 2006 177 740
- US-A1- 2009 159 808
- US-B1- 7 641 349
- D A TICHENOR ET AL: "Recent results in the development of an integrated EUV laboratory tool", PROCEEDINGS OF THE SPIE, vol. 2437, 1995, page 292-307, XP000002656696,
- C MONTCALM ET AL: "Multilayer reflective coatings for extreme-ultraviolet lithography", PROCEEDINGS OF THE SPIE, vol. 3331, 1998, pages 42-51, XP000002656697,
- DISCLOSED ANONYMOUSLY: "Increasing thermal conductivity of EUV reticles", RESEARCH DISCLOSURE, MASON PUBLICATIONS, HAMPSHIRE, GB, vol. 529, no. 33, 1 May 2008 (2008-05-01), page 417, XP007138166, ISSN: 0374-4353

## Description

### CROSS-REFERENCE TO RELATED APPLICATIONS

The present application claims priority from Japanese Patent Application No. 2010-070988 filed on March 25, 2010, and Japanese Patent Application No. 2010-283717 filed on December 20, 2010.

### BACKGROUND

### 1. Technical Field

This disclosure relates to a mirror and an extreme ultraviolet light generation system.

### 2. Related Art

In an extreme ultraviolet light generation system employing a laser-produced-plasma (LPP) method in which plasma produced by application of a laser beam onto a target is used, a target material in a chamber is irradiated with a laser beam, thereby being turned into plasma, and, among rays of light emitted from the plasma, rays at desired wavelengths, for example, rays of extreme ultraviolet (EUV) light at a wavelength of 13.5 nm, are selectively reflected. The EUV light is reflected by an EUV collector mirror having a concave reflective surface that collects rays of light emitted at one point. The EUV light collected by the EUV collector mirror is propagated to an exposure apparatus, where the EUV light is used for photolithography, laser processing, and so forth.

JP2006-177740A discloses a mirror comprising a substrate; a thermal diffusion layer provided on a principal surface of the substrate, the thermal diffusion layer having a higher thermal conductivity than the substrate; and a reflective layer provided on the thermal diffusion layer, the reflective layer having a lower thermal conductivity than the thermal diffusion layer, wherein the reflective layer includes any of gold, molybdenum, and silver.

"Increasing thermal conductivity of EUV reticles" (Mason publications, Hampshire, GB, vol. 529, No. 33, 1 May 2008, page 417) discloses ultra low expansion glass (ULE) which may be used as the substrate material for EUV reticles. The ULE substrate for an EUV has a thermally conductive layer formed on the principle surface of the substrate which is made from material such as aluminum, copper, diamond, diamond like carbon and boron nitride.

### SUMMARY

A mirror according to various embodiments of the invention is provided in accordance with claims 1, 4 and 5.

An extreme ultraviolet light generation system according to various embodiments of the invention is provided in accordance with claims 7, 9 and 10.

These and other objects, features, aspects, and advantages of this disclosure will become apparent to those skilled in the art from the following detailed description, which, taken in conjunction with the annexed drawings, discloses preferred embodiments of this disclosure.

### BRIEF DESCRIPTION OF DRAWINGS

FIG. 1 schematically shows an EUV light generation system according to a first embodiment of this disclosure.
FIG. 2 is a sectional view schematically showing a configuration of the EUV light generation system shown in FIG. 1, taken along line II-II.
FIG. 3 is a sectional view schematically showing a configuration of a mirror according to the first embodiment.
FIG. 4 shows a heat distribution resulting from the application of a laser beam to a mirror which only includes a substrate.
FIG. 5 shows a heat distribution resulting from the application of a laser beam to a mirror which includes a 400-µm-thick thermal diffusion layer of diamond provided on a surface of the substrate to which the laser beam is applied.
FIG. 6 is a graph showing the relationship between the surface deformation of the mirror and the thickness of the diamond layer.
FIG. 7 is a sectional view schematically showing a configuration of a mirror according to a second embodiment of this disclosure.
FIG. 8 is a sectional view schematically showing a configuration of a mirror according to a third embodiment of this disclosure.
FIG. 9 is a sectional view schematically showing a configuration of a mirror according to a modification of the third embodiment.

### DESCRIPTION OF PREFERRED EMBODIMENTS

Selected embodiments of this disclosure will now be described in detail with reference to the accompanying drawings. The shape, the size, and the positional relationship shown in the drawings do not limit the scope of this disclosure. In addition, part of the hatching in the sectional views is omitted in order to show the configuration clearly. Furthermore, numerical values given in the following description are only preferable examples of this disclosure and therefore do not limit the scope of this disclosure.

### First Embodiment

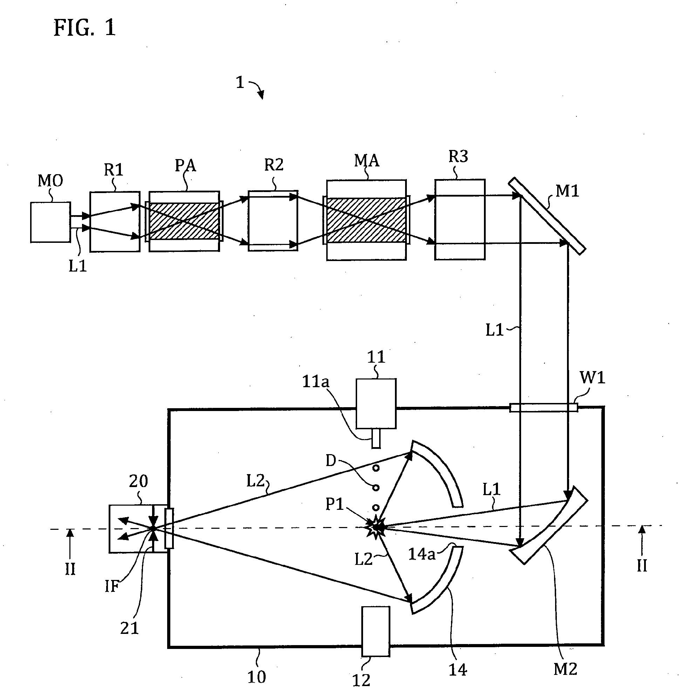

An EUV light generation system and a mirror included therein according to a first embodiment of this disclosure will now be described in detail with reference to the relevant drawing. FIG. 1 schematically shows an EUV light generation system 1 according to the first embodiment. The EUV light generation system 1 may include a driver laser for outputting a laser beam L1 with which a target material is irradiated, a chamber 10 defining a space where EUV light is generated, and a focusing optical system for focusing the laser beam L1 outputted from the driver laser at a specific position in a plasma generation region P1 inside the chamber 10.

As shown in FIG. 1, the driver laser may include a master oscillator MO, a preamplifier PA, a main amplifier MA, and relay optical systems R1 through R3. The master oscillator MO may output a laser beam L1 at a wavelength band that matches one or more of a plurality of amplification lines of the amplifiers (the preamplifier PA and the main amplifier MA) disposed downstream thereof. The master oscillator MO may be configured, for example, of a single laser which may output the laser beam L1 through single-line or multi-line oscillation. Alternatively, the master oscillator MO may be configured of a plurality of lasers, each of which may output a laser beam through single-line or multi-line oscillation and a combiner for combining the laser beams from the respective lasers into the laser beam L1. A laser may be any of a semiconductor laser such as a quantum cascade laser, a gas laser containing CO₂ gas or the like as a gain medium, and a solid-state laser containing titanium-sapphire or the like. The laser may also be a distributed-feedback laser. The laser may be either a continuous-wave (CW) laser which outputs a continuous wave or a pulsed laser which intermittently outputs a pulsed laser beam. The master oscillator MO may also include: a wavelength-selecting unit, such as a grating, for selecting rays at specific wavelengths from the laser beam outputted from a laser; a resonator-length-adjusting unit for adjusting the resonator length of the laser; and so forth, in order to match the wavelength band of the laser beam L1 to be outputted therefrom with the one or more of the plurality of the amplification lines of the amplifiers (the preamplifier PA and the main amplifier MA) disposed downstream thereof.

The relay optical system R1 may expand the diameter of the laser beam L1 such that the laser beam L1 outputted from the master oscillator MO may fill substantially the entirety of the amplification region in the preamplifier PA. The preamplifier PA may include, for example, excited CO₂ gas as a major gain medium. The preamplifier PA may amplify, among rays of the laser beam L1 outputted from the master oscillator MO, rays at wavelengths that match the amplification line(s) thereof.

The laser beam L1 amplified by the preamplifier PA may pass through the relay optical system R2, where the diameter of the laser beam L1 may be expanded such that the laser beam L1 may fill substantially the entirety of the amplification region of the main amplifier MA. The main amplifier MA may include, for example, excited CO₂ gas as a major gain medium, as in the preamplifier PA. The main amplifier MA may further amplify, among rays of the laser beam L1 that has been amplified by the preamplifier PA, rays at wavelengths that match the amplification line(s) thereof. In the first embodiment, the preamplifier PA and the main amplifier MA may include the same type of gain medium. Therefore, the preamplifier PA and the main amplifier MA may amplify the laser beam L1 at the same amplification line(s).

The laser beam L1 amplified by the main amplifier MA may pass through the relay optical system R3, where the laser beam L1 may be collimated. The collimated laser beam L1 may be reflected by a high-reflection flat mirror M1 of the focusing optical system and guided into the chamber 10 through a window W1. Subsequently, the laser beam L1 may be reflected by an off-axis paraboloidal mirror M2 provided in the chamber 10. The off-axis paraboloidal mirror M2 may reflect the collimated laser beam L1 incident thereon through the window W1 so that the laser beam L1 may be focused in the plasma generation region P1 inside the chamber 10. The off-axis paraboloidal mirror M2 may alternatively be provided outside the chamber 10. In this case, the window W1 may be provided between the off-axis paraboloidal mirror M2 and the plasma generation region P1 inside the chamber 10.

The chamber 10 may be provided with a droplet generator 11, which stores a target material (for example, Sn) serving as a plasma source in a molten state. The droplet generator 11 may include a nozzle 11a having at the tip thereof an opening facing the plasma generation region P1. A droplet D of Sn may be outputted through the nozzle 11a toward the plasma generation region P1. The droplet generator 11 may output the droplet D of molten Sn through the tip of the nozzle 11a by using, for example, the internal pressure. The droplet generator 11, however, is not limited to the above configuration and may be modified in various ways, for example, as a so-called electrostatic-suction type droplet generator, in which an electrode may be provided so as to face the tip of the nozzle 11a. The laser beam L1 may be focused in the plasma generation region P1 in synchronization with the timing at which the droplet D arrives at the plasma generation region P1. With this, the droplet D supplied into the chamber 10 may be turned into plasma in the plasma generation region P1.

The chamber 10 may also be provided with a droplet-collecting unit 12 for collecting droplets D which have passed through the plasma generation region P1, part of a droplet D that has not been turned into plasma by the application of the laser beam L1 thereto, and the like. The droplet-collecting unit 12 may be provided, for example, on the extension of a virtual line connecting the tip of the nozzle 11a of the droplet generator 11 and the plasma generation region P1, or, if the droplet D follows a curved trajectory, on the extension of the curved trajectory.

The chamber 10 may also be provided thereinside with an EUV collector mirror 14, which selectively reflects rays of the EUV light L2 emitted at specific wavelengths from the plasma generated in the plasma generation region P1. The EUV collector mirror 14 may be provided, for example, between the off-axis paraboloidal mirror M2 and the plasma generation region P1 such that the reflective surface thereof faces the plasma generation region P1. The EUV collector mirror 14 may have a through-hole 14a formed substantially at the center thereof. The laser beam L1 reflected by the off-axis paraboloidal mirror M2 may travel through the through-hole 14a and be focused in the plasma generation region P1.

The EUV light L2 emitted from the plasma generated in the plasma generation region P1 may be reflected by the EUV collector mirror 14 and be focused at an intermediate focus IF defined at an aperture 21 provided in an exposure-apparatus-connecting unit 20 connecting the chamber 10 to an exposure apparatus (not shown). The EUV light L2 focused at the intermediate focus IF may subsequently be guided to the exposure apparatus through an optical system (not shown).

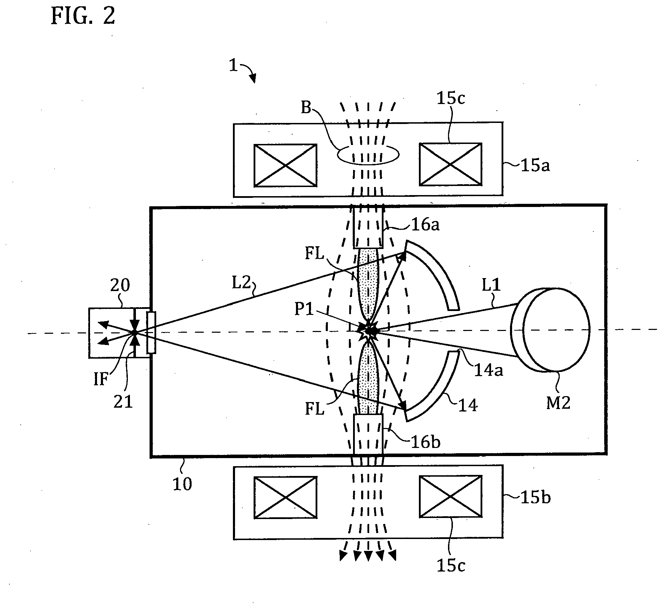

FIG. 2 is a sectional view schematically showing the configuration of the EUV light generation system 1 shown in FIG. 1, taken along line II-II. As shown in FIG. 2, a pair of magnetic-field-generating units 15a and 15b may be provided outside the chamber 10 such that a virtual line connecting the centers of the respective bores thereof may pass through the plasma generation region P1. The magnetic-field-generating units 15a and 15b may each include an electromagnetic coil 15c. When electric current is supplied from a power supply (not shown) to the electromagnetic coils 15c, a magnetic field B, of which the center of the magnetic flux passes through the plasma generation region P1, may be generated. Debris particles, such as charged particles including Sn ions, derived from the plasma generated in the plasma generation region P1 may be trapped in the magnetic field B. Subsequently, the trapped charged particles may move along the magnetic flux of the magnetic field B, thereby forming an ion flow FL.

Cylindrical ion-collecting units 16a and 16b may be provided in the chamber 10, on a virtual line along the center of the magnetic flux of the magnetic field B. The ion-collecting units 16a and 16b may each have a cylindrical shape having an opening provided on one side thereof facing the plasma generation region P1. The ion flow FL moving along the magnetic field B may subsequently be collected into either one of the ion-collecting units 16a and 16b. Accordingly, the Sn debris particles generated in the plasma generation region P1 may be collected into the ion-collecting units 16a and 16b. The collected Sn debris particles may be reused as the target material.

A mirror according to the first embodiment will now be described in detail with reference to the relevant drawing. The mirror according to the first embodiment is applicable to any of the mirrors described above, including the high-reflection flat mirror M1, the off-axis paraboloidal mirror M2, the EUV collector mirror 14, and mirrors included in the relay optical systems R1 through R3.

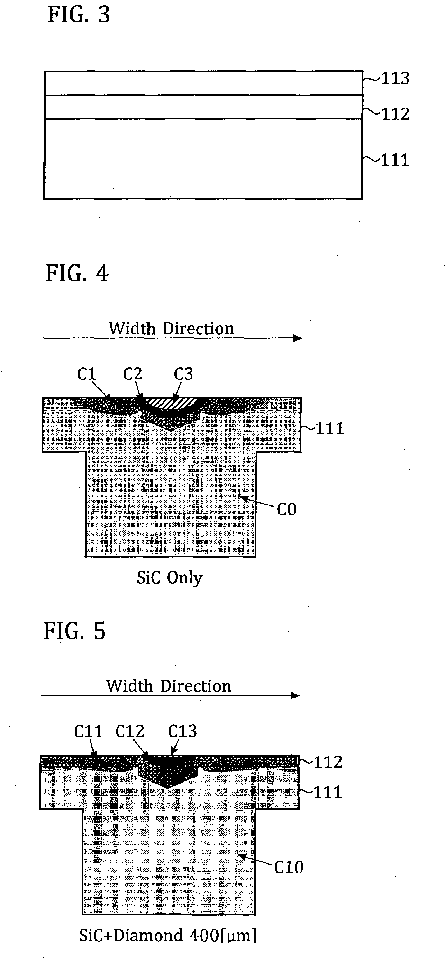

FIG. 3 is a sectional view schematically showing the configuration of the mirror according to the first embodiment. The section shown in FIG. 3 is taken along a plane perpendicular to the reflective surface of the mirror. As shown in FIG. 3, the mirror may include a substrate 111, a thermal diffusion layer 112 provided on a principal surface of the substrate 111, and a high-reflection film 113 provided on the thermal diffusion layer 112. The principal surface of the substrate 111 is the reflective side of the mirror.

The substrate 111 may function as a support for the thermal diffusion layer 112 and the high-reflection film 113 provided thereon. The substrate 111 may also function as a heat releasing unit for releasing heat from the thermal diffusion layer 112 and the high-reflection film 113. The material for the substrate 111 may, for example, be silicon carbide (SiC) but is not limited thereto, and may be any of the following: aluminum nitride (AlN), alumina (Al₂O₃), silicon nitride (SiN), zirconia (ZrO₂), a compound of alumina and titanium carbide, titanium-carbide-based cermet, graphite, and so forth.

Table 1 below summarizes the Vickers hardness, thermal expansion coefficients, and thermal conductivities of the above materials. Table 2 summarizes the thermal expansion coefficient and the thermal conductivity of graphite.

**Table 1**

| Material | Vickers hardness [Kg/mm²] | Thermal expansion coefficient x10⁻⁶ [1/°C] | Thermal conductivity [W/m·K] |
|---|---|---|---|
| silicon carbide (SiC) | 2300 | 4.0 | 150 |
| aluminum nitride (AlN) | 1040 | 4.8 | 400 |
| Alumina (Al₂O₃) | 1800 | 7.9 | 60 |
| silicon nitride (SiN) | 1480 | 2.6 | 60 |
| zirconia (ZrO₂) | 1350 | 9.6 | 14 |
| alumina and titanium carbide (Al₂O₃+TiC) | 2000 | 7.5 | 50 |
| titanium-carbide-based cermet | 1900 | 8.1 | 30 |

**Table 2**

| Material | Thermal expansion coefficient x10⁻⁶ [1/°C] | Thermal conductivity [W/m·K] |
|---|---|---|
| graphite | 3 | 200 |

The material for the substrate 111 preferably has a high thermal conductivity and a small thermal expansion coefficient so that the substrate 111 can exhibit high stability to heat. Referring to Tables 1 and 2, among the materials listed above, silicon carbide (SiC) or aluminum nitride (AlN) may be suitable for the substrate 111. As another alternative, silicon (Si) may also be suitable for the substrate 111. It is more preferable that the substrate 111 include a material that is easy to process and costs low.

The thermal diffusion layer 112 provided on the substrate 111 may function as a heat releasing member for releasing heat from the high-reflection film 113. The thermal diffusion layer 112 has a thickness of, for example, approximately 200 microns to several millimeters. The thermal diffusion layer 112 is formed of a material having a higher thermal conductivity than the high-reflection film 113 provided thereon. Providing such thermal diffusion layer 112 as described above over the principal surface of the substrate 111 may allow the heat accumulated in the high-reflection film 113 provided on the thermal diffusion layer 112 to be diffused over the entirety of the contacting portion between the thermal diffusion layer 112 and the substrate 111. With this, the heat accumulated in the high-reflection film 113 can be released efficiently to the substrate 111.

The material for the thermal diffusion layer 112 may, for example, be diamond but is not limited thereto, and may be any of the following materials having a high thermal conductivity: diamond-like carbon (DLC), graphite, and so forth. Further, the thermal diffusion layer 112 may include a plurality of layers including at least two of diamond, DLC, and graphite. Table 3 below summarizes the thermal conductivities of diamond and DLC. The thermal conductivity of graphite is shown in Table 2.

**Table 3**

| Materials | Thermal conductivity [W/m·K] |
|---|---|
| Diamond | 2000 |
| DLC | 800-2000 |

As summarized in Table 3, both diamond and DLC have thermal conductivities of approximately 2000 W/m·K, which is higher than those of the materials listed for the substrate 111. Referring to Table 2, graphite has a higher thermal conductivity than the materials, including silicon carbide (SiC), suitable for the substrate 111. There may be provided no thermal diffusion layer but only a substrate including a material having a high thermal conductivity. In a situation where the mirror is exposed to high-energy light and is required to exhibit high optical performance, a cooling mechanism or a positioning mechanism may often be provided, and the substrate therefore tends to have a complex shape. For example, a fluid channel for temperature control may generally be provided in the substrate. In such a case, if the substrate is made, for example, of diamond, the substrate may be difficult to process and may tend to cost high. Therefore, by adding a thermal diffusion layer, the substrate can include a material which is easy to process and costs low. Consequently, a mirror which may cost low and exhibit high thermal stability can be provided, despite the complex shape thereof.

The mirror may have the high-reflection film 113 on the reflective side thereof. The material for the high-reflection film 113 may, for example, be gold (Au) but is not limited thereto, and may be any of molybdenum (Mo), silver (Ag), and so forth. The high-reflection film 113 may have a thickness of approximately 1 µm, for example.

The thermal diffusion layer 112 may be formed by any of the following methods: plasma chemical vapor deposition (CVD), ion beam deposition, cathode arc deposition, and so forth. The high-reflection film 113 may be formed by any of the following methods: sputtering, CVD, plating, deposition, and so forth.

FIGS. 4 and 5 show heat distributions resulting from the application of a laser beam in a case where the mirror only includes the substrate 111 and in a case where the mirror includes a thermal diffusion layer 112 including diamond on the substrate 111. In the following description, the substrate 111 may include SiC, and a laser beam is applied to the center of the principal surface of the substrate 111. FIG. 4 shows the heat distribution resulting from the application of a laser beam to a mirror which only includes the substrate 111. FIG. 5 shows the heat distribution resulting from the application of a laser beam to a mirror including a 400-µm-thick, thermal diffusion layer 112 of diamond provided on the surface of the substrate 111 to which the laser beam is applied.

Comparing the distributions shown in FIGS. 4 and 5, in the case where the mirror only includes the SiC substrate 111, the heat generated by the application of the laser beam may concentrate near the portion to which the laser beam is applied. Therefore, in the case where the mirror only includes the SiC substrate 111, a high-temperature region C3 having a relatively high temperature may extend over a wide area of the substrate 111 around the portion to which the laser beam is applied. In contrast, in the case shown in FIG. 5, where the mirror includes the thermal diffusion layer 112 on the surface of the substrate 111 to which the laser beam is applied, a high-temperature region C13 having a relatively high temperature may be very small, compared with the high-temperature region C3 shown in FIG. 4. In addition, in the case shown in FIG. 4, not only the high-temperature region C3 but also a first moderate-temperature region C2 having a lower temperature than the high-temperature region C3 and a second moderate-temperature region C1 having a lower temperature than the first moderate-temperature region C2 may concentrate on a region near the surface to which the laser beam is applied and near the portion to which the laser beam is applied. Therefore, in the case shown in FIG. 4, there is a low-temperature region C0 having a lower temperature, about the normal temperature, than the second moderate-temperature region C1 on the periphery of the region near the surface to which the laser beam is applied. In contrast, in the case shown in FIG. 5, a first moderate-temperature region C12 having a lower temperature than the high-temperature region C13 and a second moderate-temperature region C11 having a lower temperature than the first moderate-temperature region C12 may extend over the surface to which the laser beam is applied, with substantially no low-temperature region C10 having a lower temperature, about the normal temperature, than the second moderate-temperature region C11 near the surface to which the laser beam is applied. This may demonstrate that the heat accumulated at the portion to which the laser beam is applied may be widely diffused by the thermal diffusion layer 112 and consequently released efficiently through the entirety of the substrate 111.

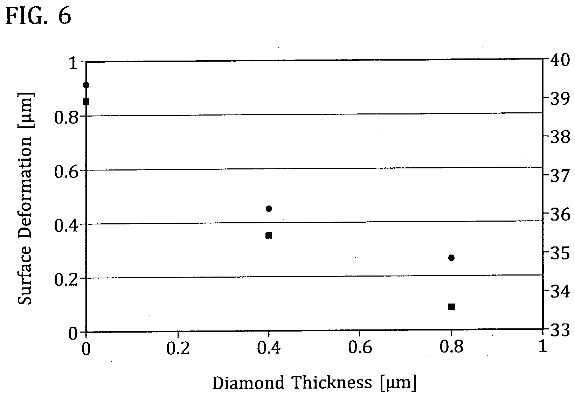

The relationship between the deformation occurring in the surface of the mirror (hereinafter referred to as the surface deformation) and the thickness of the diamond layer (the thermal diffusion layer 112) provided on the substrate 111 will now be described. FIG. 6 is a graph showing the relationship between the surface deformation in the mirror and the thickness of the diamond layer. As shown in FIG. 6, the more the thickness of the thermal diffusion layer 112 (diamond layer) on the substrate 111 is increased, the further the surface deformation in the mirror may be reduced. This may demonstrate that the stability to heat may be increased by increasing the thickness of the thermal diffusion layer 112 (diamond layer) provided on the substrate 111.

In the first embodiment, the thermal diffusion layer 112 may be interposed between the high-reflection film 113 and the substrate 111 of the mirror. With this, according to the first embodiment, a mirror which may exhibit excellent stability to heat and an EUV light generation system including such mirror can be obtained.

### Second Embodiment

An EUV light generation system and a mirror included therein according to a second embodiment of this disclosure will now be described in detail with reference to the relevant drawing. The EUV light generation system according to the second embodiment may have substantially the same configuration as the EUV light generation system according to the first embodiment, and duplicate description thereof is omitted here.

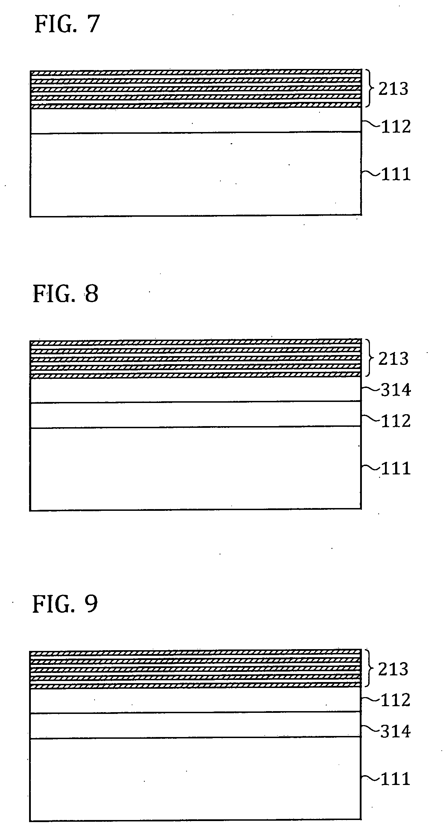

FIG. 7 is a sectional view schematically showing the configuration of the mirror according to the second embodiment. As shown in FIG. 7, the mirror according to the second embodiment may have substantially the same configuration as the mirror shown in FIG. 3, except in that a high-reflection multi-layer film 213 including a plurality of layers may be provided on the thermal diffusion layer 112 in place of the high-reflection film 113. The high-reflection multi-layer film 213 may have a multi-layer structure including, for example, dielectric layers and metal layers being alternately laminated. In this case, a metal layer may be the topmost layer in the multi-layer structure. That is, the metal layer may constitute the reflective surface of the mirror. The dielectric layers may include one or more of the following dielectric materials: zinc selenide (ZnSe), thorium fluoride (ThF₄), silicon (Si), and so forth. The metal layers may include one or more of the following materials: gold (Au), molybdenum (Mo), silver (Ag), and so forth. For example, the EUV collector mirror 14 may include dielectric layers including silicon and metal layers including molybdenum. Alternatively, the high-reflection multi-layer film 213 may only include dielectric layers. In that case, layers having a large dielectric constant and layers having a small dielectric constant may be laminated alternately. For example, if the layers having a large dielectric constant include zinc selenide (ZnSe) and the layers having a small dielectric constant include thorium fluoride (ThF₄), a dielectric multi-layer film having a high reflectivity to a CO₂ laser beam may be provided. The mirror configured as described above may be used as a laser-beam-focusing mirror or a propagation mirror provided in the laser-beam path.

The high-reflection multi-layer film 213 may be formed by any of the following methods: CVD, sputtering, plating, deposition, and so forth.

In the second embodiment configured as described above, the thermal diffusion layer 112 may diffuse the heat accumulated in the high-reflection multi-layer film 213, as in the first embodiment, whereby the heat may efficiently be released through the entirety of the substrate 111. With this, a mirror that may exhibit excellent stability to heat and an EUV light generation system including such mirror may be obtained. Other configurations are substantially the same as those described in the first embodiment, and duplicate description thereof is omitted here.

### Third Embodiment

An EUV light generation system and a mirror included therein according to a third embodiment of this disclosure will now be described in detail with reference to the relevant drawing. The EUV light generation system according to the third embodiment has substantially the same configuration as the EUV light generation system according to the first or second embodiment, and duplicate description thereof is omitted here.

FIG. 8 is a sectional view schematically showing the configuration of the mirror according to the third embodiment. As shown in FIG. 8, the mirror according to the third embodiment may have substantially the same configuration as the mirror shown in FIG. 7, except in that a smoothing layer 314 may be interposed between the thermal diffusion layer 112 and the high-reflection multi-layer film 213. The smoothing layer 314 may reduce the irregularities in the surface of the thermal diffusion layer 112 provided thereunder, thereby smoothing the surface of the high-reflection multi-layer film 213 provided thereon. With this, the optical performance of the high-reflection multi-layer film 213 may be prevented from easily changing with the quality of the thermal diffusion layer 112, and the flexibility in selecting the materials for the layers and the method of forming the layers may be increased. Consequently, a low-cost mirror may be obtained. The smoothing layer 314 may also relax the internal stress generated due to an unbalanced heat distribution or the like occurring at the interface with the high-reflection multi-layer film 213 provided thereon and at the interface with the thermal diffusion layer 112 provided thereunder, thereby reducing the deformation occurring in the reflective surface of the mirror. The material for the smoothing layer 314 may be any of the following: nickel (Ni), nickel phosphide (NiP), silicon (Si), silicon oxide (SiOx), silicon carbide (SiC), and so forth.

The smoothing layer 314 may be formed by any of the following methods: CVD, sputtering, plating, deposition, and so forth.

In the third embodiment, the smoothing layer 314 may be interposed between the thermal diffusion layer 112 and the high-reflection multi-layer film 213, which is a reflective layer. With this, according to the third embodiment, a mirror that may exhibit more excellent stability to heat and an EUV light generation system including such mirror can be obtained at low costs. While the above description concerns a case where the smoothing layer 314 according to the third embodiment is applied to the mirror according to the second embodiment shown in FIG. 7, this disclosure is not limited thereto. The smoothing layer 314 according to the third embodiment may also be applied to the mirror according to the first embodiment shown in FIG. 3. Other configurations are substantially the same as those described in the first or second embodiment, and duplicate description thereof is omitted here.

### Modification

While the third embodiment concerns a case where the smoothing layer 314 may be interposed between the thermal diffusion layer 112 and the high-reflection multi-layer film 213, this disclosure is not limited thereto. FIG. 9 is a sectional view schematically showing the configuration of a mirror according to a modification of the third embodiment. As shown in FIG. 9, the smoothing layer 314 may be interposed between the substrate 111 and the thermal diffusion layer 112. In such a configuration as well, the smoothing layer 314 may relax the internal stress generated due to an unbalanced heat distribution or the like occurring at the interface with a set of the high-reflection multi-layer film 213 and the thermal diffusion layer 112 provided thereon and at the interface with the substrate 111 provided thereunder, thereby reducing the deformation occurring in the reflective surface of the mirror.

The above embodiments including the modifications thereof are only exemplary embodiments of this disclosure, and this disclosure is not limited thereto. Moreover, it is obvious from the foregoing description that various modifications made to this disclosure are practicable within the scope of the invention which is defined by the appended claims only.

## Claims

1. A mirror comprising:
a substrate (111);
a thermal diffusion layer (112) provided on a principal surface of the substrate, the thermal diffusion layer (112) having a higher thermal conductivity than the substrate; and
a reflective layer (113, 213) provided on the thermal diffusion layer (112), the reflective layer (113, 213) having a lower thermal conductivity than the thermal diffusion layer (112),
wherein the reflective layer (113, 213) includes any of gold, molybdenum, and silver,
**characterized in that**
the thermal diffusion layer (112) includes at least one of diamond, diamond-like carbon, and graphite, and
the substrate (111) includes any of graphite, silicon carbide, and aluminum nitride.

2. The mirror according to Claim 1, wherein the reflective layer (213) has a multi-layer structure.

3. The mirror according to Claim 2, wherein the multi-layer structure (213) includes: a dielectric layer including at least one of zinc selenide, thorium fluoride, and silicon; and a metal layer including at least one of gold, molybdenum, and silver.

4. A mirror comprising:
a substrate (111);
a thermal diffusion layer (112) provided on a principal surface of the substrate (111), the thermal diffusion layer (112) having a higher thermal conductivity than the substrate (111); a smoothing layer (314) provided on the thermal diffusion layer;
and a reflective layer (113, 213) provided on the smoothing layer, the reflective layer having a lower thermal conductivity than the thermal diffusion layer (112),
wherein the reflective layer (113, 213) includes any of gold, molybdenum, and silver,
**characterized in that**
the thermal diffusion layer (112) includes at least one of diamond, diamond-like carbon, and graphite,
and
the substrate (111) includes any of graphite, silicon carbide, and aluminum nitride.

5. A mirror comprising:
a substrate (111);
a thermal diffusion layer (112) having a higher thermal conductivity than the substrate (111); and
a reflective layer (113, 213) provided on the thermal diffusion layer (112), the reflective layer (113, 213) having a lower thermal conductivity than the thermal diffusion layer (112),
wherein the reflective layer (113, 213) includes any of gold, molybdenum, and silver,
**characterized in that**
a smoothing layer (314) is provided on a principal surface of the substrate (111);
the thermal diffusion layer (112) is provided on the smoothing layer (314),
the thermal diffusion layer (112) includes at least one of diamond, diamond-like carbon, and graphite, and
the substrate (111) includes any of graphite, silicon carbide, and aluminum nitride.

6. The mirror according to Claim 4 or 5, wherein the smoothing layer (314) includes any of nickel, nickel phosphide, silicon, silicon oxide, and silicon carbide.

7. An extreme ultraviolet light generation system used with a laser apparatus, the extreme ultraviolet light generation system comprising:
a chamber;
a target generator provided to the chamber for supplying a target material into the chamber; and
at least one mirror including a substrate (111), a thermal diffusion layer (112) provided on a principal surface of the substrate (111), and a reflective layer (113, 213) provided on the thermal diffusion layer (112), the reflective layer (113, 213) having a lower thermal conductivity than the thermal diffusion layer (112),
wherein the reflective layer (113, 213) includes any of gold, molybdenum, and silver,
**characterized in that**
the thermal diffusion layer (112) includes at least one of diamond, diamond-like carbon, and graphite, and
the substrate (111) includes any of graphite, silicon carbide, and aluminum nitride.

8. The extreme ultraviolet light generation system according to Claim 7, wherein the reflective layer (113, 213) has a multi-layer structure.

9. An extreme ultraviolet light generation system used with a laser apparatus, the extreme ultraviolet light generation system comprising:
a chamber;
a target generator provided to the chamber for supplying a target material into the chamber; and
at least one mirror including a substrate (111), a thermal diffusion layer (112) provided on a principal surface of the substrate (111), a smoothing layer (314) provided on the thermal diffusion layer (112), and a reflective layer (113, 213) provided on the smoothing layer, the reflective layer (113, 213) having a lower thermal conductivity than the thermal diffusion layer (112),
wherein
the reflective layer (113, 213) includes any of gold, molybdenum, and silver, **characterized in that**
the thermal diffusion layer (112) includes at least one of diamond, diamond-like carbon, and graphite, and
the substrate (111) includes any of graphite, silicon carbide, and aluminum nitride.

10. An extreme ultraviolet light generation system used with a laser apparatus, the extreme ultraviolet light generation system comprising:
a chamber;
a target generator provided to the chamber for supplying a target material into the chamber; and
at least one mirror including a substrate (111), a smoothing layer (314) provided on a principal surface of the substrate (111), a thermal diffusion layer (112) provided on the smoothing layer, and a reflective layer (113, 213) provided on the thermal diffusion layer (112), the reflective layer (113, 213) having a lower thermal conductivity than the thermal diffusion layer (112),
wherein
the reflective layer (113, 213) includes any of gold, molybdenum, and silver,
the thermal diffusion layer (112) includes at least one of diamond, diamond-like carbon, and graphite,
and
the substrate (111) includes any of graphite, silicon carbide, and aluminum nitride.

11. The extreme ultraviolet light generation system according to Claim 9 or 10, wherein the at least one mirror is a focusing mirror for focusing a laser beam on the target material in the chamber.

12. The extreme ultraviolet light generation system according to Claim 9 or 10, wherein the at least one mirror is an EUV collector mirror for collecting extreme ultraviolet light emitted when the target material is turned into plasma in the chamber.

## Patentansprüche

1. Spiegel mit:
einem Substrat (111);
einer Thermodiffusionsschicht (112), die auf einer Hauptfläche des Substrats vorgesehen ist, wobei die Thermodiffusionsschicht (112) eine höhere Wärmeleitfähigkeit als das Substrat aufweist; und
einer Reflexionsschicht (113, 213), die auf der Thermodiffusionsschicht (112) vorgesehen ist, wobei die Reflexionsschicht (113, 213) eine niedrigere Wärmeleitfähigkeit als die Thermodiffusionsschicht (112) aufweist,
wobei die Reflexionsschicht (113, 213) irgendeines von Gold, Molybdän und Silber aufweist,
**dadurch gekennzeichnet, dass**
die Thermodiffusionsschicht (112) mindestens eines von Diamant, diamantförmigem Kohlenstoff und Graphit aufweist, und
das Substrat (111) irgendeines von Graphit, Siliziumkarbid und Aluminiumnitrid aufweist.

2. Spiegel nach Anspruch 1, wobei die Reflexionsschicht (213) eine Mehrschichtstruktur aufweist.

3. Spiegel nach Anspruch 2, wobei die Mehrschichtstruktur (213) umfasst: eine dielektrische Schicht, die mindestens eines von Zinkselenid, Thoriumfluorid und Silizium aufweist; und eine Metallschicht, die irgendeines von Gold, Molybdän und Silber aufweist.

4. Spiegel mit:
einem Substrat (111);
einer Thermodiffusionsschicht (112), die auf einer Hauptfläche des Substrats (111) vorgesehen ist, wobei die Thermodiffusionsschicht (112) eine höhere Wärmeleitfähigkeit als das Substrat (111) aufweist;
einer Glättungsschicht (314), die auf der Thermodiffusionsschicht vorgesehen ist; und
einer Reflexionsschicht (113, 213), die auf der Glättungsschicht vorgesehen ist, wobei die Reflexionsschicht eine niedrigere Wärmeleitfähigkeit als die Thermodiffusionsschicht (112) aufweist,
wobei die Reflexionsschicht (113, 213) irgendeines von Gold, Molybdän und Silber aufweist,
**dadurch gekennzeichnet, dass**
die Thermodiffusionsschicht (112) mindestens eines von Diamant, diamantförmigem Kohlenstoff und Graphit aufweist, und
das Substrat (111) irgendeines von Graphit, Siliziumkarbid und Aluminiumnitrid aufweist.

5. Spiegel mit:
einem Substrat (111);
einer Thermodiffusionsschicht (112) die eine höhere Wärmeleitfähigkeit als das Substrat (111) aufweist; und
einer Reflexionsschicht (113, 213), die auf der Thermodiffusionsschicht (112) vorgesehen ist, wobei die Reflexionsschicht (113, 213) eine niedrigere Wärmeleitfähigkeit als die Thermodiffusionsschicht (112) aufweist,
wobei die Reflexionsschicht (113, 213) irgendeines von Gold, Molybdän und Silber aufweist,
**dadurch gekennzeichnet, dass**
eine Glättungsschicht (314) auf einer Hauptfläche des Substrats (111) vorgesehen ist;
die Thermodiffusionsschicht (112) auf der Glättungsschicht (314) vorgesehen ist,
die Thermodiffusionsschicht (112) mindestens eines von Diamant, diamantförmigem Kohlenstoff und Graphit aufweist, und
das Substrat (111) irgendeines von Graphit, Siliziumkarbid und Aluminiumnitrid aufweist.

6. Spiegel nach Anspruch 4 oder 5, wobei die Glättungsschicht (314) irgendeines von Nickel, Nickelphosphid, Silizium, Siliziumoxid und Siliziumkarbid aufweist.

7. System zur Erzeugung von Licht im extremen Ultraviolett, das mit einer Laservorrichtung verwendet wird, wobei das System zur Erzeugung von Licht im extremen Ultraviolett aufweist:
eine Kammer;
einen Targetgenerator, der für die Kammer zum Zuführen eines Targetmaterials in die Kammer vorgesehen ist; und
mindestens einen Spiegel, der ein Substrat (111), eine Thermodiffusionsschicht (112), die auf einer Hauptfläche des Substrats (111) vorgesehen ist, und eine Reflexionsschicht (113, 213) aufweist, die auf der Thermodiffusionsschicht (112) vorgesehen ist, wobei die Reflexionsschicht (113, 213) eine niedrigere Wärmeleitfähigkeit als die Thermodiffusionsschicht (112) aufweist,
wobei die Reflexionsschicht (113, 213) irgendeines von Gold, Molybdän und Silber aufweist,
**dadurch gekennzeichnet, dass**
die Thermodiffusionsschicht (112) mindestens eines von Diamant, diamantförmigem Kohlenstoff und Graphit aufweist, und
das Substrat (111) irgendeines von Graphit, Siliziumkarbid und Aluminiumnitrid aufweist.

8. System zur Erzeugung von Licht im extremen Ultraviolett nach Anspruch 7, wobei die Reflexionsschicht (113, 213) eine Mehrschichtstruktur aufweist.

9. System zur Erzeugung von Licht im extremen Ultraviolett, das mit einer Laservorrichtung verwendet wird, wobei das System zur Erzeugung von Licht im extremen Ultraviolett aufweist:
eine Kammer;
einen Targetgenerator, der für die Kammer zum Zuführen eines Targetmaterials in die Kammer vorgesehen ist; und
mindestens einen Spiegel, der ein Substrat (111), eine Thermodiffusionsschicht (112), die auf einer Hauptfläche des Substrats (111) vorgesehen ist, eine Glättungsschicht (314), die auf der Thermodiffusionsschicht (112) vorgesehen ist, und eine Reflexionsschicht (113, 213) aufweist, die auf der Glättungsschicht vorgesehen ist, wobei die Reflexionsschicht (113, 213) eine niedrigere Wärmeleitfähigkeit als die Thermodiffusionsschicht (112) aufweist,
wobei
die Reflexionsschicht (113, 213) irgendeines von Gold, Molybdän und Silber aufweist,
**dadurch gekennzeichnet, dass**
die Thermodiffusionsschicht (112) mindestens eines von Diamant, diamantförmigem Kohlenstoff und Graphit aufweist, und
das Substrat (111) irgendeines von Graphit, Siliziumkarbid und Aluminiumnitrid aufweist.

10. System zur Erzeugung von Licht im extremen Ultraviolett, das mit einer Laservorrichtung verwendet wird, wobei das System zur Erzeugung von Licht im extremen Ultraviolett aufweist:
eine Kammer;
einen Targetgenerator, der für die Kammer zum Zuführen eines Targetmaterials in die Kammer vorgesehen ist; und
mindestens einen Spiegel, der ein Substrat (111), eine Glättungsschicht (314), die auf einer Hauptfläche des Substrats (111) vorgesehen ist, eine Thermodiffusionsschicht (112), die auf der Glättungsschicht vorgesehen ist, und eine Reflexionsschicht (113, 213) aufweist, die auf der Thermodiffusionsschicht (112) vorgesehen ist, wobei die Reflexionsschicht (113, 213) eine niedrigere Wärmeleitfähigkeit als die Thermodiffusionsschicht (112) aufweist,
wobei
die Reflexionsschicht (113, 213) irgendeines von Gold, Molybdän und Silber aufweist,
die Thermodiffusionsschicht (112) mindestens eines von Diamant, diamantförmigem Kohlenstoff und Graphit aufweist, und
das Substrat (111) irgendeines von Graphit, Siliziumkarbid und Aluminiumnitrid aufweist.

11. System zur Erzeugung von Licht im extremen Ultraviolett nach Anspruch 9 oder 10, wobei der mindestens eine Spiegel ein fokussierender Spiegel zum Fokussieren eines Laserstrahls auf das Targetmaterial in der Kammer ist.

12. System zur Erzeugung von Licht im extremen Ultraviolett nach Anspruch 9 oder 10, wobei der mindestens eine Spiegel ein EUV-Sammelspiegel zum Sammeln von Licht im extremen Ultraviolett ist, das emittiert wird, wenn das Targetmaterial in der Kammer in Plasma verwandelt wird.

## Revendications

1. Miroir, comprenant :
un substrat (111) ;
une couche de diffusion thermique (112) prévue sur une surface principale du substrat, ladite couche de diffusion thermique (112) ayant une conductivité thermique supérieure à celle du substrat ; et
une couche de réflexion (113, 213) prévue sur la couche de diffusion thermique (112), ladite couche de réflexion (113, 213) ayant une conductivité thermique inférieure à celle de la couche de diffusion thermique (112),
où la couche de réflexion (113, 213) contient de l'or, du molybdène ou de l'argent,
**caractérisé**
**en ce que** la couche de diffusion thermique (112) contient du diamant et/ou du carbone de type diamant et/ou du graphite, et
**en ce que** le substrat (111) contient du graphite, du carbure de silicium ou du nitrure d'aluminium.

2. Miroir selon la revendication 1, où la couche de réflexion (213) a une structure multi-couche.

3. Miroir selon la revendication 2, où la structure multi-couche (213) comprend : une couche diélectrique contenant du séléniure de zinc et/ou du fluorure de thorium et/ou du silicium ; et une couche métallique contenant de l'or et/ou du molybdène et/ou de l'argent.

4. Miroir comprenant :
une substrat (111) ;
une couche de diffusion thermique (112) prévue sur une surface principale du substrat, ladite couche de diffusion thermique (112) ayant une conductivité thermique supérieure à celle du substrat (111) ;
une couche de lissage (314) prévue sur la couche de diffusion thermique ; et
une couche de réflexion (113, 213) prévue sur la couche de lissage, ladite couche de réflexion ayant une conductivité thermique inférieure à celle de la couche de diffusion thermique (112),
où la couche de réflexion (113, 213) contient de l'or, du molybdène ou de l'argent,
**caractérisé**
**en ce que** la couche de diffusion thermique (112) contient du diamant et/ou du carbone de type diamant et/ou du graphite, et
**en ce que** le substrat (111) contient du graphite, du carbure de silicium ou du nitrure d'aluminium.

5. Miroir comprenant :
un substrat (111) ;
une couche de diffusion thermique (112) ayant une conductivité thermique supérieure à celle du substrat (111) ; et
une couche de réflexion (113, 213) prévue sur la couche de diffusion thermique (112), ladite couche de réflexion (113, 213) ayant une conductivité thermique inférieure à celle de la couche de diffusion thermique (112),
où la couche de réflexion (113, 213) contient de l'or, du molybdène ou de l'argent,
**caractérisé**
**en ce qu'**une couche de lissage (314) est prévue sur une surface principale du substrat (111) ;
la couche de diffusion thermique (112) est prévue sur la couche de lissage (314),
la couche de diffusion thermique (112) contient du diamant et/ou du carbone de type diamant et/ou du graphite, et
**en ce que** le substrat (111) contient du graphite, du carbure de silicium ou du nitrure d'aluminium.

6. Miroir selon la revendication 4 ou la revendication 5, où la couche de lissage (314) contient du nickel, du phosphure de nickel, du silicium, de l'oxyde de silicium ou du carbure de silicium.

7. Système générateur de lumière ultraviolette extrême utilisé avec un dispositif laser, ledit système générateur de lumière ultraviolette extrême comprenant :
une chambre ;
un générateur de cible prévu sur la chambre pour alimenter la chambre en matériau de cible ; et
au moins un miroir comprenant un substrat (111), une couche de diffusion thermique (112) prévue sur une surface principale du substrat (111), et une couche de réflexion (113, 213) prévue sur la couche de diffusion thermique (112), ladite couche de réflexion (113, 213) ayant une conductivité thermique inférieure à celle la couche de diffusion thermique (112),
où la couche de réflexion (113, 213) contient de l'or, du molybdène ou de l'argent,
**caractérisé**
**en ce que** la couche de diffusion thermique (112) contient du diamant et/ou du carbone de type diamant et/ou du graphite, et
**en ce que** le substrat (111) contient du graphite, du carbure de silicium ou du nitrure d'aluminium.

8. Système générateur de lumière ultraviolette extrême selon la revendication 7, où la couche de réflexion (113, 213) a une structure multi-couche.

9. Système générateur de lumière ultraviolette extrême utilisé avec un dispositif laser, ledit système générateur de lumière ultraviolette extrême comprenant :
une chambre ;
un générateur de cible prévu sur la chambre pour alimenter la chambre en matériau de cible ; et
au moins un miroir comprenant un substrat (111), une couche de diffusion thermique (112) prévue sur une surface principale du substrat (111), une couche de lissage (314) prévue sur la couche de diffusion thermique (112), et une couche de réflexion (113, 213) prévue sur la couche de lissage, ladite couche de réflexion (113, 213) ayant une conductivité thermique inférieure à celle la couche de diffusion thermique (112),
où
la couche de réflexion (113, 213) contient de l'or, du molybdène ou de l'argent,
**caractérisé**
**en ce que** la couche de diffusion thermique (112) contient du diamant et/ou du carbone de type diamant et/ou du graphite, et
**en ce que** le substrat (111) contient du graphite, du carbure de silicium ou du nitrure d'aluminium.

10. Système générateur de lumière ultraviolette extrême utilisé avec un dispositif laser, ledit système générateur de lumière ultraviolette extrême comprenant :
une chambre ;
un générateur de cible prévu sur la chambre pour alimenter la chambre en matériau de cible ; et au moins un miroir comprenant un substrat (111) (111), une couche de lissage (314) prévue sur une surface principale du substrat (111), une couche de diffusion thermique (112) prévue sur la couche de lissage, et une couche de réflexion (113, 213) prévue sur la couche de diffusion thermique (112), ladite couche de réflexion (113, 213) ayant une conductivité thermique inférieure à celle la couche de diffusion thermique (112),
où
la couche de réflexion (113, 213) contient de l'or, du molybdène ou de l'argent,
la couche de diffusion thermique (112) contient du diamant et/ou du carbone de type diamant et/ou du graphite, et
le substrat (111) contient du graphite, du carbure de silicium ou du nitrure d'aluminium.

11. Système générateur de lumière ultraviolette extrême selon la revendication 9 ou la revendication 10, où ledit au moins un miroir est un miroir de focalisation destiné à focaliser un faisceau laser sur le matériau de cible dans la chambre.

12. Système générateur de lumière ultraviolette extrême selon la revendication 9 ou la revendication 10, où ledit au moins un miroir est un miroir collecteur de rayonnement EUV destiné à recevoir la lumière ultraviolette extrême émise quand le matériau de cible est converti en plasma dans la chambre.
